# EUROPÄISCHE PATENTSCHRIFT

(11) **EP 3 047 553 B1**
(45) Veröffentlichungstag und Bekanntmachung des Hinweises auf die Patenterteilung: **25.10.2017**
(21) Anmeldenummer: 14758509.5
(22) Anmeldetag: 24.07.2014
(51) Int. Cl.: H02G 3/06, H01R 9/05, H02G 15/068, H01R 13/53, H01R 24/38, H05K 9/00, H01R 13/6596

(54) **ABSCHIRMUNGSANORDNUNG FÜR HOCHSTROMANWENDUNGEN**
SHIELDING ARRANGEMENT FOR HIGH-CURRENT APPLICATIONS
DISPOSITIF DE BLINDAGE POUR APPLICATIONS COURANT DE FORTE INTENSITÉ

(30) Priorität: 18.09.2013 DE 102013218726
(43) Veröffentlichungstag der Anmeldung: 27.07.2016
(73) Patentinhaber: Robert Bosch GmbH, 70442 Stuttgart (DE)
(72) Erfinder: SAUR, Martin, 73084 Salach (DE); HU, Zhenyu, 71229 Leonberg (DE)
(86) Internationale Anmeldenummer: PCT/EP2014/065969
(87) Internationale Veröffentlichungsnummer: WO 2015/039791

(56) Entgegenhaltungen:
- EP-A1- 1 313 171
- DE-T2- 69 805 088
- DE-U1-202005 014 601
- US-A- 6 007 383

## Beschreibung

### Gebiet der Erfindung

Die Erfindung betrifft elektrische Verbindungsanordnungen. Insbesondere betrifft die Erfindung eine Abschirmungsanordnung für Verbindungsanordnungen in Hochstromanwendungen.

### Stand der Technik

Elektrische Verbindunganordnungen können dazu dienen, eine elektrische Verbindung zwischen zwei oder mehreren Bauteilen herzustellen. Hierbei kann es sich beispielsweise um Steckverbindungen oder Leitungen handeln.

Insbesondere bei Hochstromanwendungen können um einen elektrischen Leiter elektromagnetische Felder entstehen. Um eine Beeinträchtigung der Umgebung des Leiters durch diese elektromagnetischen Felder zu vermeiden, kann beispielsweise eine umlaufende Abschirmung erforderlich sein. Bei Hochstromleitungen kann hierzu in der Leitungsisolation beispielsweise ein Schirmgeflecht integriert sein.

Elektromagnetische Abschirmungen können auch für Verbindungsanordnungen notwendig sein. Durch die mechanischen und elektrischen Anforderungen an diese Verbindungsanordnungen und das Auftreten von teils sehr hohen Strömen im Bereich von beispielsweise 50 bis 300 A werden mitunter hohe Anforderungen an die Qualität der elektrischen Kontaktierung und an die Robustheit des mechanischen Aufbaus gestellt. Gleichzeitig kann eine möglichst gute elektromagnetische Abschirmung erforderlich sein. Die Berücksichtigung aller dieser Anforderungen kann in vielen Fällen Kompromisse hinsichtlich bestimmter Merkmale erforderlich machen.

Aus der DE 698 05 088 T2, der EP 1 313 171 A1, der US 6 007 383 A und der DE 20 2005 014601 U sind Anordnungen zum Verbinden der Abschirmung eines Gehäuses und eines geschirmten Kabels bekannt.

### Offenbarung der Erfindung

Ausführungsformen der Erfindung liegen unter anderem die folgenden Überlegungen zugrunde: Komponenten von Hochstromverbindungsanordnungen, beispielsweise von Steckverbindungen, können zur elektromagnetischen Abschirmung beispielsweise von einem Schirmblech umgeben sein. Dabei kann das Schirmblech eine Verbindungsanordnung entweder vollständig oder teilweise umschließen und so eine wirksame Abschirmung elektromagnetischer Felder erreichen. Dieses Schirmblech kann dabei aus einem metallischen Material gefertigt und elektrisch leitfähig sein. Zur Verbindung des Schirmblechs mit einer Kabelabschirmung eines Anschlusskabels kann eine möglicherweise vorhandene Außenisolation des Anschlusskabels teilweise entfernt und die freigelegte Kabelabschirmung mit dem Schirmblech elektrisch und mechanisch verbunden werden. Dies kann beispielsweise durch Crimpen oder Klemmen erfolgen. Da auch in der Kabelabschirmung und dem Schirmblech teils hohe Ströme auftreten können, ist eine zuverlässige Kontaktierung zwischen diesen Komponenten bei geringem elektrischem Widerstand wünschenswert. Aufgrund von Bewegungen des Anschlusskabels relativ zum Schirmgehäuse, beispielsweise durch Vibrationen oder während der Montage, kann zusätzlich eine mechanische Entkopplung von Anschlusskabel und Schirmgehäuse notwendig sein.
Mit der vorliegenden Erfindung kann unter anderem eine mechanische Stabilität, eine elektrische Kontaktierung und/oder eine elektromagnetische Abschirmung einer Verbindungsanordnung für Hochstromanwendungen verbessert werden.
Es wird daher eine Abschirmungsanordnung für Hochstromanwendungen gemäß Anspruch 1 vorgeschlagen. Ein Vorteil kann in einer besseren elektrischen Kontaktierung bei verbesserter mechanischer Entkopplung von Abschirmgehäuse und Anschlusskabel gesehen werden. Weiterhin kann ein geringerer Verschleiß der Kontaktstelle über die Lebensdauer ermöglicht werden.
Eine Abschirmungsanordnung kann zur Verringerung der durch den elektrischen Strom verursachten elektromagnetischen Felder in einem Bereich außerhalb der Abschirmungsanordnung dienen. Hierbei dient die Kabelabschirmung des Anschlusskabels zur Verringerung der in der Umgebung des Anschlusskabels auftretenden elektromagnetischen Felder, die durch den im isolierten Leiter transportierten elektrischen Strom verursacht werden können. Die Durchführung des Abschirmgehäuses kann dazu dienen, das Anschlusskabel mit dem stromführenden elektrischen Leiter in einen Innenbereich des Abschirmgehäuses führen zu können.
Unter einer Abschirmhülse kann beispielsweise ein rohrförmiges metallisches Bauteil verstanden werden, dessen Innendurchmesser ein Durchführen des isolierten Leiters durch die Abschirmhülse erlauben kann und dessen Außendurchmesser vorzugsweise so gewählt ist, dass die Abschirmhülse zumindest im gehäuseseitigen Hülsenbereich in die Durchführung eingeführt werden kann. Gleichzeitig ist der Außendurchmesser der Abschirmhülse so gewählt, dass eine elektrische und mechanische Kontaktierung der Abschirmhülse mit dem Abschirmgehäuse möglich ist. Der gehäuseseitige Hülsenbereich kann dabei einen gleichen oder unterschiedlichen Außendurchmesser und/oder einen gleichen oder unterschiedlichen Innendurchmesser im Vergleich zum kabelseitigen Hülsenbereich aufweisen. Der kabelseitige Hülsenbereich ist mit seiner Mantelfläche mit der Kabelabschirmung in mechanischem und elektrischem Kontakt. Dies kann beispielsweise durch Klemmen, Löten oder Crimpen erreicht werden.
Mit anderen Worten kann die Abschirmhülse als mechanisches und elektrisches Bindeglied zwischen dem Anschlusskabel und dem Abschirmgehäuse verstanden werden.

Die Abschirmungsanordnung dient gemäß einem Beispiel der elektromagnetischen Abschirmung eines einzelnen isolierten Leiters. In einem weiteren Beispiel dient die Abschirmungsanordnung der elektromagnetischen Abschirmung einer Vielzahl von isolierten Leitungen, beispielsweise als Sammelabschirmung oder Summenabschirmung von mehreren Leitungen.

In einem Beispiel kann der gehäuseseitige Hülsenbereich und der kabelseitige Hülsenbereich voneinander beabstandet an der Abschirmhülse angeordnet sein. Mit anderen Worten kann sich zwischen den beiden Hülsenbereichen ein Zwischenbereich befinden, so dass die beiden Hülsenbereiche nicht direkt ineinander übergehen. In einem weiteren Beispiel schließt sich der gehäuseseitige Hülsenbereich direkt an den kabelseitigen Hülsenbereich an.

In einer Ausführungsform der Erfindung ist ein Durchmesser des isolierten Leiters kleiner, beispielsweise um mehr als 10%, vorzugsweise mehr als 20%, als ein Innendurchmesser der Abschirmhülse, so dass der isolierte Leiter in einem Innenbereich der Abschirmhülse in radialer Richtung bewegbar ist. Durch den kleineren Durchmesser des isolierten Leiters ergibt sich vorteilhafterweise ein Bewegungsspielraum des isolierten Leiters innerhalb der Abschirmhülse. Hierdurch ist eine radiale Bewegung des isolierten Leiters in begrenztem Umfang möglich. Dies kann den Vorteil haben, dass eine radiale Bewegung oder Verschiebung des isolierten Leiters nicht oder nur begrenzt zu einer radial anliegenden Kraft auf die Abschirmhülse führen kann. Mit anderen Worten kann somit eine mechanische Entkopplung oder Bewegungsentkopplung erreicht werden. Dadurch kann beispielsweise beim Einsatz der Verbindungsanordnung in der Umgebung von Verbrennungsmotoren eine Übertragung von Vibrationen zwischen Anschlusskabel und Schirmgehäuse verringert oder vermieden werden. Dies bewirkt vorteilhaft auch eine Verringerung des Risikos, dass es z.B. durch Vibrationen oder Temperaturwechselvorgänge an der Übergangsstelle zu einer Materialermüdung und infolgedessen zu einem Bruch der Verbindungsstelle kommt. Auch wird dadurch vorteilhaft das Risiko für die Ausbildung von Lecks für elektromagnetische Strahlung an der Übergangsstelle verringert, die beispielsweise durch Materialermüdung oder Scheuervorgänge auftreten könnten.

Ein isolierter Leiter kann beispielsweise einen massiven Draht oder Litzen, jeweils beispielsweise aus Kupfer oder einer Kupferlegierung, aufweisen und beispielsweise einen Leiterquerschnitt von bis zu 75 mm² haben. Der Leiter kann umfänglich von einer den Leiter einschließenden Isolationsschicht umgeben sein, die beispielsweise aus Kunststoff oder anderen geeigneten Materialien bestehen kann.

In einer Ausführungsform der Erfindung ist die Kabelabschirmung außerhalb des Abschirmgehäuses und außerhalb der Schirmhülse in einem an die Schirmhülse angrenzenden Bereich relativ zum isolierten Leiter radial bewegbar, so dass die Kabelabschirmung in diesem Bereich und die Abschirmhülse relativ zueinander mechanisch entkoppelt sind. Die radiale Bewegbarkeit der Kabelabschirmung in Bezug auf die Abschirmhülse erlaubt, in gewissen Grenzen, eine voneinander mechanisch entkoppelte radiale Bewegung der Abschirmhülse bzw. des Anschlusskabels relativ zueinander. Hierdurch kann vorteilhafterweise die Übertragung von Bewegungen oder Verschiebungen, wie beispielsweise Vibrationen, zwischen dem Anschlusskabel und der Abschirmhülse verringert oder verhindert werden. In einem Beispiel ist zusätzlich zur radialen Bewegbarkeit der Kabelabschirmung auch der isolierte Leiter innerhalb der Abschirmhülse radial bewegbar. In einem weiteren Beispiel ist die Kabelabschirmung des Anschlusskabels auf ihrer Außenseite von einer äußeren Isolationsschicht umgeben, die beispielsweise aus Kunststoff bestehen kann.

In einer Ausführungsform der Erfindung wird die radiale Bewegbarkeit dadurch erreicht, dass die Kabelabschirmung in diesem Bereich, d.h. außerhalb des Abschirmgehäuses und außerhalb der Schirmhülse in einem an die Schirmhülse angrenzenden Bereich, in ihrer Form veränderbar ist und in diesem Bereich in radialer Richtung aufgeweitet ist. Ein Vorteil des Aufweitens kann darin gesehen werden, dass hierdurch der notwendige Bewegungsspielraum geschaffen wird, der die radiale Bewegung ermöglicht. Das Aufweiten kann als einfache Möglichkeit der Erhöhung eines Umfanges der Kabelabschirmung gesehen werden, die mit vergleichsweise einfachen Mitteln erfolgen kann. Beispielsweise kann sich eine zusätzliche Beweglichkeit der Kabelabschirmung in Form einer Drahtlitze durch die Ausweitung ergeben, da hierbei die jeweiligen Abstände zwischen den einzelnen Litzendrähten vergrößert werden. Durch eine derartige, beispielsweise als Schirmgeflecht ausgeführte, Kabelabschirmung wird die Schirmung vorteilhaft verbessert und auch eine mechanische Entkopplung zwischen der Anschlussleitung und der Abschirmhülse bzw. dem Abschirmgehäuse verbessert. Gemäß der Erfindung bildet das Abschirmgehäuse im Bereich der Durchführung Kontaktlaschen nach außen aus, die sich im Wesentlichen parallel zur Mantelfläche des gehäuseseitigen Hülsenbereiches erstrecken und ausgeführt sind, mit der Mantelfläche des gehäuseseitigen Hülsenbereichs in Anlage zu kommen. Ein Vorteil solcher Kontaktlaschen kann in einer größeren Kontaktfläche zwischen dem Abschirmgehäuse und der Mantelfläche des gehäuseseitigen Hülsenbereiches gesehen werden, die höhere Reibungskräfte und/oder Kontaktkräfte und dadurch einen besseren mechanischen Halt ermöglichen können. Außerdem wird dadurch verhindert, dass sich ein Spalt zwischen den Kontaktlaschen und dem Hülsenbereich bzw. zwischen der Durchführung und dem Hülsenbereich auftut, der als eine Art Leck für elektromagnetische Strahlung wirken könnte. Dadurch wir eine besonders effektive Abschirmung bewirkt.
Kontaktlaschen können beispielsweise als quer zu einer Seitenfläche des Abschirmgehäuses verlaufende Auskragungen oder Ausragungen verstanden werden. Beispielsweise können im Bereich der Durchführung Blechsegmente am Rand der Durchführung nach außen gebogen werden und somit als Kontaktlaschen dienen.
Gemäß einer Ausführungsform der Erfindung weist die Abschirmungsanordnung im gehäuseseitigen Hülsenbereich und/oder im kabelseitigen Hülsenbereich ein in Umfangsrichtung außen um die Abschirmhülse umlaufendes Befestigungsband auf. Das Befestigungsband ist ausgestaltet, einen Anpressdruck auf die jeweiligen Außenflächen der Kontaktlaschen oder einen Anpressdruck auf die Kabelabschirmung in Richtung der Mantelflächen der Abschirmhülse zu erzeugen, sodass die Kontaktlaschen und/oder die Kabelabschirmung an den jeweiligen Mantelflächen der Abschirmhülse befestigt sind.
Ein Vorteil des Befestigungsbandes kann in einem im Wesentlichen über den Umfang der Abschirmhülse gleichmäßig verteilten Anpressdruck gesehen werden. Das Befestigungsband kann weiterhin einen Anpressdruck der Kontaktlaschen bzw. der Kabelabschirmung an die jeweiligen Mantelflächen vorteilhaft erhöhen, sodass eine sichere mechanische und/oder elektrische Kontaktierung erreicht werden kann. Desweiteren kann eine vorteilhafte Vibrationsbeständigkeit und Temperaturwechselbeständigkeit erzielt werden sowie ein geringer Verschleiß der Kontaktstelle und der Verbindungsanordnung. Durch die Verwendung eines Befestigungsbandes kann ebenfalls ein geringeres Setzverhalten unter Temperatur, also temperaturbedingte Verschiebungen, erreicht werden. Ein weiterer Vorteil kann darin gesehen werden, dass das Befestigungsband zu geringen Kosten hergestellt werden und vergleichsweise einfach montiert werden kann. Durch das Befestigungsband wird überdies vorteilhaft eine leckfreie Abschirmung bewirkt, indem auf einfache Art und Weise an allen Übergangsstellen zwischen Gehäuse/Kontaktlaschen und Abschirmhülse bzw. zwischen Kabelschirmung und Abschirmhülse eine umfänglich verlaufende elektrisch leitende Verbindung hergestellt ist.

In einer Ausführungsform der Erfindung ist ein Umfang des Befestigungsbandes einstellbar, um einen Anpressdruck der Kontaktlaschen und/oder der Kabelabschirmung an die Mantelflächen der Abschirmhülse verändern zu können. Durch den einstellbaren Umfang kann beispielsweise eine begrenzte Elastizität des Befestigungsbandes genutzt werden, um die sich daraus ergebende radiale Anpresskraft zu verändern. In einem Beispiel kann durch Verringerung des Umfanges des Befestigungsbandes ein Anpressdruck erhöht werden.

Ein Umfang des Befestigungsbandes kann beispielsweise durch das Durchführen des Befestigungsbandes durch eine an einem Ende des Befestigungsbandes angeordnete Lasche und geeignetes Fixieren des Befestigungsbandes in der Lasche erreicht werden. Das Befestigungsband kann insbesondere ähnlich einem Kabelbinder ausgestaltet sein.

Durch das Befestigungsband wird vorteilhaft eine modulare Herstellung der Einzelkomponenten ermöglicht und auch eine besonders einfache, schnelle und kostengünstige Montage der Einzelkomponenten zu einer eine effektive Schirmung bewirkenden Abschirmungsanordnung bewirkt. Zudem erlaubt die Verwendung eines Befestigungsbandes auch eine schnelle Demontage der Abschirmungsanordnung, z.B., wenn das Anschlusskabel gewechselt werden muss. Eine derartige Demontage ist für die Einzelkomponenten der Abschirmungsanordnung beschädigungsfrei durchführbar.

In einer Ausführungsform der Erfindung weist das Befestigungsband ein Metall auf. Ein Vorteil kann darin gesehen werden, dass ein beispielsweise aus einem Federstahl gefertigtes Befestigungsband bei wenig Eigengewicht einen vergleichsweise hohen Anpressdruck erzeugen kann. Desweiteren kann ein metallisches Befestigungsband eine erhöhte mechanische Stabilität aufweisen. Besonders vorteilhaft wird durch ein metallisches Befestigungsband in einfacher Weise eine leckfreie und effektive Schirmung des elektromagnetischen Feldes bewirkt, welches durch das stromführende Anschlusskabel im Inneren der Abschirmanordnung vorliegt.

In einer Ausführungsform der Erfindung weist das Befestigungsband einen Kunststoff auf und ist ausgestaltet, die Kabelabschirmung mit der Mantelfläche des kabelseitigen Hülsenbereiches konturnah zu umschließen. Ein Vorteil von Kunststoff kann darin gesehen werden, dass beispielsweise durch Erwärmung ein Anpassen an die jeweilige individuelle Form der jeweiligen Mantelflächen zusammen mit den Kontaktlaschen bzw. zusammen mit der Kabelabschirmung ermöglicht werden kann. Mit anderen Worten kann eine Oberfläche der Abschirmhülse zusammen mit den jeweils anliegenden Kontaktlaschen oder der Kabelabschirmung eng umschlossen werden, sodass sich das Kunststoff-Befestigungsband gegebenenfalls auch an radiale Schwankungen im Umfang der Mantelfläche anpassen kann. Eine weitere beispielhafte Ausführung sieht einen Metall-Kunststoff-Verbund als Material für das Befestigungsband vor, z.B. metallisch beschichteten Kunststoff. Dieses vereint die mechanischen Vorteile des Kunststoffes mit dem Vorteil einer leckfreien Schirmung von elektromagnetischer Strahlung durch die Metallbeschichtung.

In einer Ausführungsform der Erfindung ist das Befestigungsband eine Schrumpfhülse. Ein Vorteil von Schrumpfhülsen kann darin gesehen werden, dass durch einfache Erwärmung, beispielsweise durch Heißluft, ein konturnahes Umschließen der Abschirmhülse und der Kontaktlaschen bzw. Kabelabschirmung durch den Kunststoff möglich sein kann. Schrumpfhülsen können dadurch gekennzeichnet sein, dass sie beispielsweise durch vorheriges Aufweiten und Abkühlen leicht über die Abschirmhülse bzw. die Kabelabschirmung oder die Kontaktlaschen geführt werden können und sich in einem darauffolgenden Schritt durch Erwärmung zusammenziehen. Schrumpfhülsen sind in vielen verschiedenen Ausführungsvarianten und vergleichsweise preiswert erhältlich. Weiterhin wird dadurch auch ein gutes Setzverhalten gegenüber Temperaturschwankungen im Betrieb bewirkt. Denn eine thermisch geschrumpfte Schrumpfhülse ist beispielsweise unanfällig gegen die unter normalen Betriebsbedingungen auftretenden Temperaturschwankungen und befestigt spielfrei die Kabelabschirmung an der Abschirmhülse. Gleichzeitig lässt sich eine Schrumpfhülse auch einfach und für die Kabelabschirmung und die Abschirmhülse beschädigungsfrei wieder demontieren, z.B. durch dein Einsatz von thermischen Methoden oder durch mechanische Entfernung.

In einer Ausführungsform der Erfindung weist die Abschirmhülse an den jeweiligen längsseitigen Enden der Hülsenbereiche in Umfangsrichtung umlaufende und radial nach außen gerichtete Aufwölbungen auf. Ein Vorteil der Aufwölbungen kann darin gesehen werden, dass ein Wegbewegen in Längsrichtung der an den jeweiligen Mantelflächen anliegenden Kontaktlaschen bzw. der Kabelabschirmung in Bereiche der Abschirmhülse außerhalb des gehäuseseitigen Hülsenbereiches bzw. des kabelseitigen Hülsenbereiches verhindert oder erschwert werden kann. Hierdurch kann sich eine insgesamt bessere mechanische Stabilität insbesondere hinsichtlich in axialer Richtung der Abschirmhülse wirkender Zugkräfte ergeben.

In einem Beispiel weist die Abschirmhülse drei Aufwölbungen auf, wobei zwei der Aufwölbungen jeweils an den stirnseitigen Enden der Abschirmhülse angeordnet sind und die dritte Aufwölbung als gemeinsame Aufwölbung des gehäuseseitigen Hülsenbereiches und des kabelseitigen Hülsenbereiches auf einer Länge der Abschirmhülse angeordnet ist.

Gemäß einer Ausführungsform der Erfindung verlaufen die Kontaktlaschen in Ihrer Erstreckung vom Abschirmgehäuse hin zur Mantelfläche stufenförmig, sodass ein Teilbereich der Kontaktlaschen im Bereich der Aufwölbungen von einer Zentrumsachse der Abschirmhülse weiter beabstandet ist als ein Teilbereich der Kontaktlaschen zwischen den Aufwölbungen des gehäuseseitigen Hülsenbereiches. Ein Vorteil des stufenförmigen Verlaufs kann darin gesehen werden, dass der die Mantelfläche kontaktierende Bereich der Kontaktlasche bzw. die Kabelabschirmung in einem radial tieferliegenden Bereich der Abschirmhülse angeordnet ist. Die Aufwölbungen können als mechanische Barriere verstanden werden, die ein axiales Herausbewegen der Kontaktlaschen bzw. der Kabelschirmung weg von der Mantelfläche der Abschirmhülse verhindern oder erschweren können.

Gemäß einer Ausführungsform der Erfindung ist eine Breite des Bandes in Längsrichtung der Abschirmhülse kleiner als ein Abstand zwischen den beiden Aufwölbungen der jeweiligen Hülsenbereiche. Ein Vorteil kann darin gesehen werden, dass hierdurch das Band vollständig im Bereich zwischen den Aufwölbungen angeordnet werden kann und somit eine effektive Befestigung und Kontaktierung im Bereich der Mantelflächen zwischen den Aufwölbungen ermöglicht wird. Gleichzeitig kann durch geeignete Breite des Befestigungsbandes eine möglichst große gemeinsame Kontaktfläche und somit eine günstige Verteilung der Anpresskräfte über die Mantelflächen erreicht werden.

Gemäß einer Ausführungsform der Erfindung weist der gehäuseseitige Hülsenbereich und/oder der kabelseitige Hülsenbereich an den Mantelflächen Eintiefungen und/oder Aufwölbungen auf. Ein Vorteil kann in einer Vergrößerung der effektiven Kontaktfläche und/oder in einer besseren mechanischen Verbindung zwischen der Kabelabschirmung und der Abschirmhülse bzw. zwischen den Kontaktlaschen und der Abschirmhülse gesehen werden.

Durch die Vergrößerung der Kontaktfläche wird vorteilhaft bewirkt, dass der elektrische Übergangswiderstand von dem kabelseitigen Hülsenbereich zur Kabelabschirmung verringert wird. Zusammen mit der besseren mechanischen Anbindung wird so eine über die Lebensdauer dauerhafte und zuverlässige Abschirmung der elektromagnetischen Felder des stromführenden Anschlusskabels bewirkt. Weiterhin wird durch die größere Kontaktfläche vorteilhaft das Risiko verringert, dass Lecks für elektromagnetische Strahlung zwischen der Abschirmhülse und der Kabelschirmung auftreten können. Besonders vorteilhaft ist die kabelseitige Schirmung dadurch auch dauerhaft gegen mechanische Wechselbelastungen wie z.B. durch Vibrationen oder temperaturbedingte Abmessungsänderungen unempfindlich.

Gemäß einer Ausführungsform der Erfindung ist ein Profil der Mantelflächen wellenförmig ausgestaltet. Mit anderen Worten können beispielsweise in Umfangsrichtung umlaufende Nute oder Eintiefungen vorgesehen sein. Besonders vorteilhaft ist eine derartige wellenförmige Ausgestaltung, beispielsweise einer Wellenform ohne scharfe Kanten, da dadurch die Befestigung der Kabelschirmung beispielsweise mit einer Schrumpfhülse besonders zuverlässig und beschädigungsfrei erfolgen kann und so eine zur Zerstörung der Schirmung erforderliche Abziehkraft in axialer Richtung vorteilhaft stark erhöht wird.

In einem Aspekt der Erfindung wird ein Steckverbinder für ein Kraftfahrzeug vorgeschlagen, der eine wie oben beschriebene Abschirmanordnung aufweist.

Es wird darauf hingewiesen, dass mögliche Merkmale und Vorteile einer erfindungsgemäßen Abschirmungsanordnung hierin mit Bezug auf unterschiedliche Ausführungsformen beschrieben sind. Ein Fachmann versteht, dass die einzelnen Merkmale in geeigneter Weise miteinander kombiniert oder ausgetauscht werden können, um auf diese Weise zu weiteren Ausführungsformen und möglicherweise Synergieeffekten zu gelangen.

### Kurze Beschreibung der Zeichnungen

Nachfolgend werden Ausführungsbeispiele der vorliegenden Erfindung mit Bezug auf die beigefügten Zeichnungen beschrieben, wobei weder die Beschreibung noch die Zeichnungen als die Erfindung einschränkend auszulegen sind.
Fig. 1 zeigt ein Beispiel einer erfindungsgemäßen Abschirmungsanordnung in räumlicher Darstellung.
Fig. 2 zeigt ein Beispiel einer Abschirmhülse einer erfindungsgemäßen Abschirmungsanordnung.
Fig. 3 zeigt ein Beispiel eines Abschirmgehäuses mit Kontaktlaschen als Teil einer erfindungsgemäßen Abschirmungsanordnung.
Fig. 4 zeigt ein Beispiel eines Anschlusskabels einer erfindungsgemäßen Abschirmungsanordnung.
Fig. 5 zeigt ein Beispiel einer erfindungsgemäßen Abschirmungsanordnung in einem vormontierten Zustand.
Fig. 6 zeigt ein Beispiel einer erfindungsgemäßen Abschirmungsanordnung in einem fertiggestellten Zustand.
Fig. 7 zeigt eine Schnittdarstellung eines Ausschnitts aus einer beispielhaften erfindungsgemäßen Abschirmungsanordnung mit einer wellenförmigen Mantelfläche und einem Schrumpfschlauch als Befestigungsband.

Die Figuren sind lediglich schematisch und nicht maßstabsgetreu. Gleiche Bezugszeichen bezeichnen in den Figuren gleiche oder gleich wirkende Merkmale. Sind in einer Zeichnung mehrere Merkmale gezeigt, so können diese jeweiligen Merkmale als unabhängig voneinander betrachtet werden und sind nicht zwingend in Kombination mit anderen gezeigten Merkmalen zu verstehen.

### Detaillierte Beschreibung der Ausführungsbeispiele

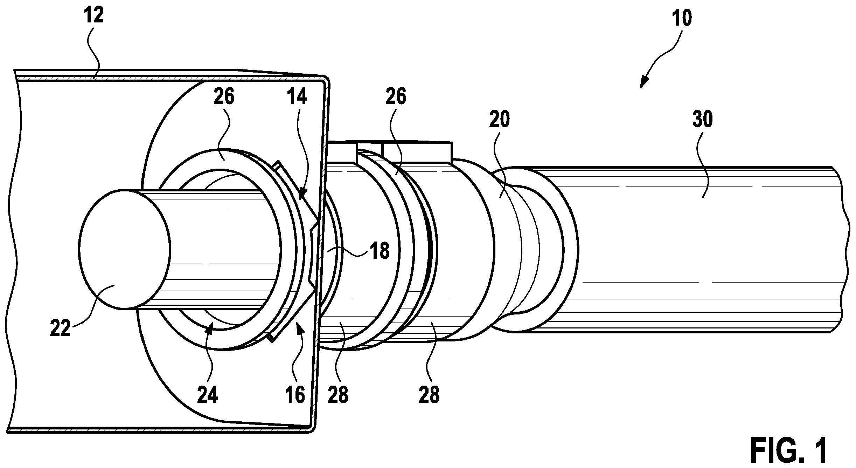

In Fig. 1 ist eine Abschirmungsanordnung 10 für Hochstromanwendungen schematisch und in räumlicher Darstellung abgebildet. Die Abschirmungsanordnung 10 weist ein Abschirmgehäuse 12 auf, an dessen Seitenfläche sich eine Durchführung 14 befindet. Von der Durchführung 14 abragend weist das Abschirmgehäuse 12 mehrere Kontaktlaschen 16 auf, die orthogonal von der Seitenfläche des Abschirmgehäuses 12 abragen. In der Durchführung 14 ist eine Abschirmhülse 18 angeordnet, die sich im hier gezeigten Beispiel vom Abschirmgehäuse 12 bis zu einer Kabelabschirmung 20 erstreckt. Die Kabelabschirmung 20 ist zusätzlich umfangsseitig außen von einer äußeren Isolationsschicht 30 umschlossen. Die Kabelabschirmung 20 umschließt einen isolierten Leiter 22, der über eine Länge der Abschirmhülse 18 durch die Abschirmhülse 18 zumindest bis in einen Innenbereich des Abschirmgehäuses 12 geführt ist. Der isolierte Leiter 22 weist in seinem Innenbereich einen elektrischen Leiter (nicht gezeigt) auf, der von einer Isolation umgeben ist. Beispielsweise kann dieser elektrische Leiter (nicht gezeigt) des isolierten Leiters 22 ein massiver Kupferdraht oder Kupferlitze sein. Die Kabelschirmung 20 kann beispielsweise als Schirmgeflecht aus Kupfer oder einem anderen hochleitfähigen Material ausgebildet sein. Beispielsweise besteht ein derartiges Schirmgeflecht aus mehreren Lagen und weist Flechtmaschen auf, welche eine effektive Schirmung der elektromagnetischen Felder des in seinem inneren verlaufenden stromführenden isolierten Leiters 22 ermöglichen. Das Schirmgeflecht kann z.B. eine gewisse Flexibilität entlang der axialen Erstreckungsrichtung aufweisen und kann dabei dehnbar sein, ohne dass der Schirmungseffekt durch Lecks für elektromagnetische Strahlung beeinträchtigt ist.

Ein Durchmesser des isolierten Leiters 22 ist im hier gezeigten Beispiel kleiner als ein Innendurchmesser der Abschirmhülse 18. Hierdurch ergibt sich ein Zwischenraum 24 zwischen dem isolierten Leiter und einer Innenwandung der Abschirmhülse 18. Dies kann vorteilhafterweise eine begrenzte radiale Beweglichkeit des isolierten Leiters 22 innerhalb der Abschirmhülse 18 ermöglichen. Die Abschirmhülse 18 weist an den jeweiligen längsseitigen Enden sowie auf einer Länge der Abschirmhülse 18 radial nach außen gerichtete Aufwölbungen 26 auf.

Die Kontaktlaschen 16 liegen an einer Mantelfläche der Abschirmhülse 18 an und werden mithilfe eines außen in Umfangsrichtung um die Abschirmhülse umlaufenden Befestigungsbandes 28 durch einen Anpressdruck auf die jeweiligen Außenflächen der Kontaktlaschen 16 an der Mantelfläche der Abschirmhülse 18 befestigt. Im hier gezeigten Beispiel ist das umlaufende Befestigungsband 28 ein aus Kunststoff gefertigter Kabelbinder.

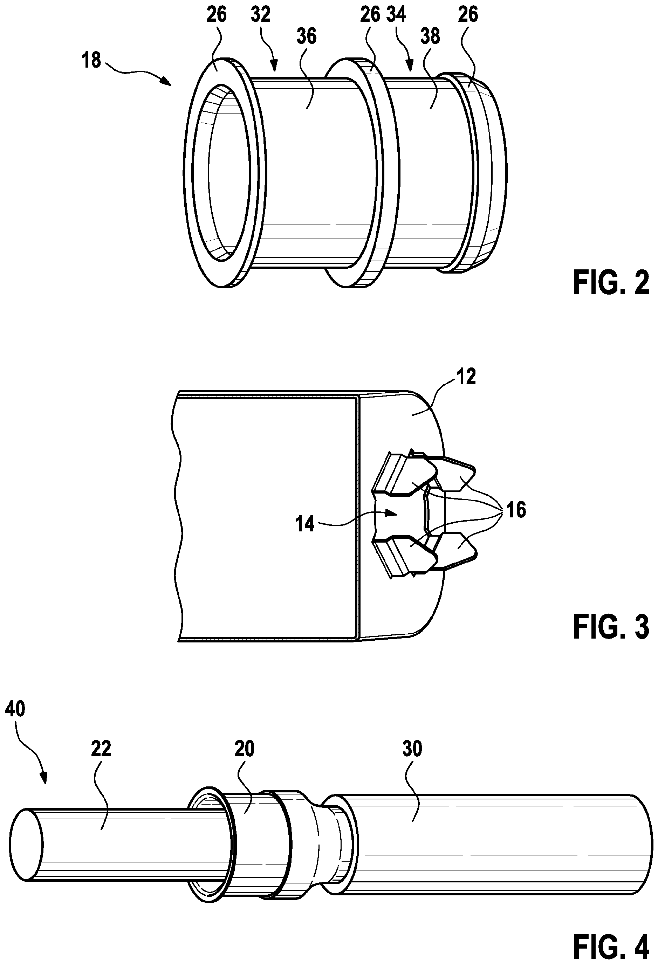

Fig. 2 zeigt eine Abschirmhülse 18 einer Abschirmungsanordnung 10 (siehe Fig. 1) gemäß der Erfindung in räumlicher Darstellung. Die Abschirmhülse 18 hat einen gehäuseseitigen Hülsenbereich 32 und einen kabelseitigen Hülsenbereich 34. Der gehäuseseitige Hülsenbereich 32 hat an seiner äußeren Oberfläche eine in Umfangsrichtung umlaufende Mantelfläche 36 des gehäuseseitigen Hülsenbereiches 32 sowie eine Mantelfläche 38 des kabelseitigen Hülsenbereiches 34. Die jeweiligen Hülsenbereiche 32, 34 weisen weiterhin jeweils an den stirnseitigen Enden Aufwölbungen 26 auf, wobei die innere dritte Auswölbung 26 eine gemeinsame Aufwölbungen 26 sowohl des gehäuseseitigen Hülsenbereiches 32 und des kabelseitigen Hülsenbereiches 34 bildet. Zum Durchführen des isolierten Leiters 22 (siehe Fig. 1) ist die Abschirmhülse 18 hohlzylindrisch ausgeführt.

Fig. 3 zeigt eine räumliche Darstellung eines Abschirmgehäuses 12 als Teil einer Abschirmungsanordnung 10 gemäß der Erfindung. Das Abschirmgehäuse 12 weist an einer Seitenfläche eine Durchführung 14 auf. Am Rand der Durchführung 14 ragen, jeweils mit einer Seite am Rand der Durchführung 14 verbunden, Kontaktlaschen 16 in orthogonaler Richtung bzw. in eine Richtung quer von der Seitenfläche ab. Die Kontaktlaschen 16 verlaufen stufenförmig in Ihrer Erstreckung vom Abschirmgehäuse 12 hin zur Mantelfläche 36 des gehäuseseitigen Hülsenbereiches 32 (siehe Fig. 2).

Fig. 4 zeigt ein Beispiel eines Anschlusskabels 40 einer Abschirmungsanordnung 10 gemäß der Erfindung mit einem isolierten Leiter 22, einer Kabelabschirmung 20 und einer Außenisolation 30. Der isolierte Leiter 22 weist im Inneren der Isolation einen elektrischen Leiter (nicht gezeigt) auf. Die Kabelabschirmung 20 ist, wie hier dargestellt, beispielsweise zum Zweck des späteren Aufschiebens auf den kabelseitigen Hülsenbereich 34 der Abschirmhülse 18 (siehe Fig. 2) in Ihrem Umfang aufgeweitet. Die Form der Ausweitung kann hierbei beispielsweise auch Aufwölbungen 26 der Abschirmhülse 18 mit berücksichtigen.

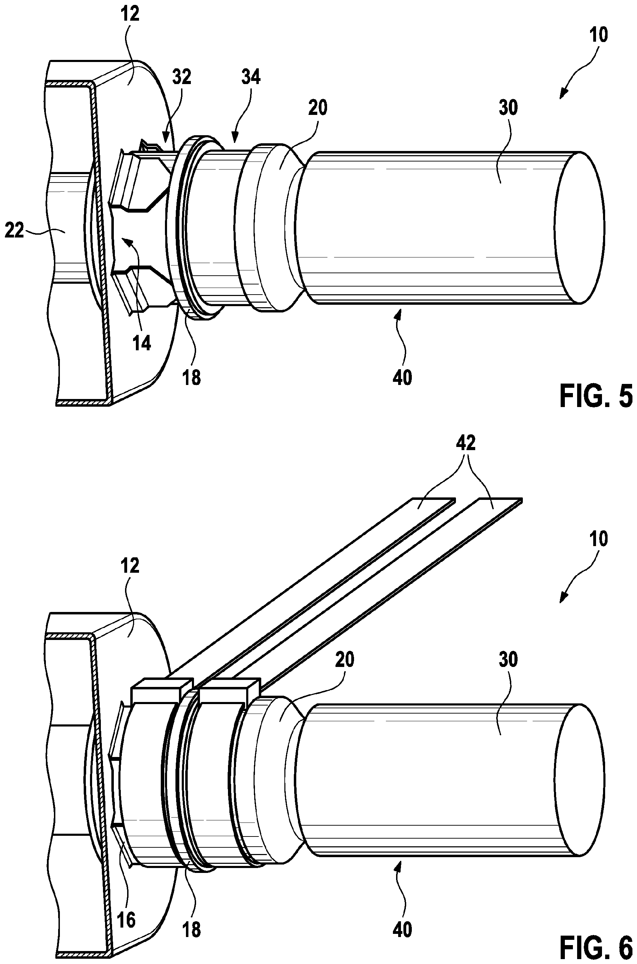

Fig. 5 und Fig. 6 zeigen vereinfacht und beispielhaft eine vormontierte und eine fertiggestellte Abschirmungsanordnung 10. Wie in Fig. 5 dargestellt, wird in einem Beispiel zunächst der gehäuseseitige Hülsenbereich 32 der Abschirmhülse 18 in die Durchführung 14 des Abschirmgehäuses 12 eingebracht. In einem weiteren Schritt wird der isolierte Leiter 22 durch die Abschirmhülse 18 hindurchgeführt. Hierzu wird vorher ein Teilstück einer eventuell vorhandenen Außenisolation 30 des Anschlusskabels 40 abisoliert und so der isolierte Leiter 22 freigelegt. Die ebenfalls vorab freigelegte Kabelabschirmung 20 wird nach dem Aufweiten über den kabelseitigen Hülsenbereich 34 gestülpt.

Entsprechend der Darstellung in Fig. 6 wird in einem darauffolgenden Schritt eine mechanische Befestigung der Kontaktlaschen 16 des Abschirmgehäuses 12 an der Abschirmhülse 18 sowie eine mechanische Befestigung der Kabelabschirmung 20 an der Abschirmhülse 18 vorgenommen. Dies erfolgt dadurch, dass ein Kabelbinder 42 jeweils umfänglich um eine Außenfläche der Kontaktlaschen 16 sowie ein weiterer Kabelbinder 42 umfänglich um die Kabelabschirmung 20 des Anschlusskabels 40 angebracht wird. Ein Umfang der Kabelbinder 42 kann hierbei beispielsweise durch Ziehen an einem abstehenden Ende des Kabelbinders 42 verkleinert werden und dadurch ein Anpressdruck der Kontaktlaschen 16 bzw. der Kabelabschirmung 20 an die Abschirmhülse 18 erhöht werden. Die Kabelabschirmung 20 ist im hier dargestellten Beispiel in einem Bereich zwischen der Außenisolation 30 und der Abschirmhülse 18 radial bewegbar, sodass das Anschlusskabel 40 mechanisch von der Abschirmhülse 18 und dem Abschirmgehäuse 12 entkoppelt ist.

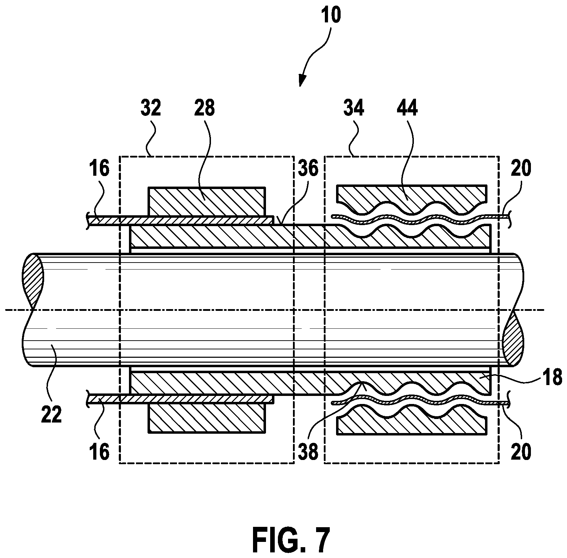

In Fig. 7 ist ein Ausschnitt aus einer beispielhaften Abschirmungsanordnung 10 gemäß der Erfindung in vereinfachter Schnittdarstellung gezeigt. Es ist eine Abschirmhülse 18 gezeigt, durch die ein isolierter Leiter 22 hindurchgeführt ist. Die Abschirmhülse 18 weist einen gehäuseseitigen Hülsenbereich 32 und einen kabelseitigen Hülsenbereich 34 auf. Im gehäuseseitigen Hülsenbereich 32 ragen Kontaktlaschen 16 von einem Abschirmgehäuse 12 (siehe Fig.1) ab und werden von einem Befestigungsband 28 an eine Mantelfläche 36 des gehäuseseitigen Hülsenbereiches 32 gepresst und hierdurch befestigt. Das Befestigungsband 28 kann beispielsweise ein Kabelbinder 42 (siehe Fig. 6) aus Kunststoff oder Metallblech sein. Im kabelseitigen Hülsenbereich 34 weist die Mantelfläche 38 der Abschirmhülse 18 in Ihrem Profil eine wellige Form auf. Die Wellenform kann beispielsweise in radialer Richtung, axialer Richtung oder auch schräger Richtung ausgeführt sein und kann eine vorteilhafte mechanische Kopplung hinsichtlich der an der Abschirmhülse 18 anliegenden Kontaktkräfte und/oder Zugkräfte bewirken.

Entlang einer Mantelfläche 38 des kabelseitigen Hülsenbereiches 34 ist eine Kabelabschirmung 20 eingebracht. Zur mechanischen Fixierung oder Befestigung der Kabelabschirmung 20 an der Mantelfläche 38 des kabelseitigen Hülsenbereiches 34 wird als Befestigungsband eine Schrumpfhülse 44 in Umfangsrichtung über die Kabelabschirmung 20 und die Mantelfläche geschoben. In der Darstellung in Fig. 7 ist die Schrumpfhülse 44 in aufgeweitetem Zustand gezeigt. In einem folgenden Schritt kann die Schrumpfhülse 44 beispielsweise durch Heißluft erwärmt werden, wodurch sich die Schrumpfhülse 44 in Ihrem Umfang verkleinert bzw. in radialer Richtung zusammenzieht. Hierdurch wird die Kabelabschirmung 20 in die wellige Mantelfläche 38 des kabelseitigen Hülsenbereiches 34 gedrückt und dadurch befestigt. In einem Beispiel ist die Schrumpfhülse aus einem Kunststoff gefertigt, was den Vorteil haben kann, dass sich eine radial nach innen gerichtete Oberflächenstruktur oder Kontur der Schrumpfhülse 44 einem Profil der Mantelfläche 38 und der Kabelabschirmung 20 gut anpassen kann. Durch das Zusammenziehen wird ein Anpressdruck in radialer Richtung nach innen auf die Abschirmhülse 18 erzeugt, was eine vorteilhafte Fixierung und elektrische Verbindung sowie mechanische Befestigung der Kabelabschirmung 20 an der Abschirmhülse 18 ermöglichen kann. Die Kabelabschirmung 20 kann hierbei beispielsweise eine Folie, Drahtlitze oder elektrisch leitfähige Gewebe sein.

Ergänzend ist darauf hinzuweisen, dass" umfassend" keine anderen Elemente oder Schritte ausschließt und "ein" oder "eine" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Abschirmungsanordnung (10) für Hochstromanwendungen, aufweisend ein Anschlusskabel (40) mit einem isolierten Leiter (22) und einer den isolierten Leiter (22) umgebenden Kabelabschirmung (20);
ein Abschirmgehäuse (12) mit einer Durchführung (14);
wobei die Abschirmungsanordnung (10) weiterhin eine hohlzylinderförmige elektrisch leitfähige Abschirmhülse (18) aufweist;
wobei der isolierte Leiter (22) durch die Abschirmhülse (18) geführt ist; wobei die Abschirmhülse (18) an einem längsseitigen Ende einen gehäuseseitigen Hülsenbereich (32) und an einem anderen längsseitigen Ende einen kabelseitigen Hülsenbereich (34) aufweist;
wobei der gehäuseseitige Hülsenbereich (32) der Abschirmhülse (18) im Bereich der Durchführung (14) des Abschirmgehäuses (12) angeordnet ist und das Abschirmgehäuse (12) mit einer Mantelfläche (36) des gehäuseseitigen Hülsenbereiches (32) in Anlage kommt;
wobei die Kabelabschirmung (22) an einer Mantelfläche (38) des kabelseitigen Hülsenbereiches (34) anliegt,
wobei die Kabelabschirmung (20) über die Abschirmhülse (18) mit dem Abschirmgehäuse (12) elektrisch verbunden ist,
**dadurch gekennzeichnet, dass**
das Abschirmgehäuse (12) im Bereich der Durchführung (14) Kontaktlaschen (16) nach außen ausbildet, die sich im Wesentlichen parallel zur Mantelfläche (36) des gehäuseseitigen Hülsenbereiches (32) erstrecken und an der Mantelfläche (36) des gehäuseseitigen Hülsenbereichs (32) anliegen.

2. Abschirmungsanordnung (10) gemäß Anspruch 1, wobei ein Durchmesser des isolierten Leiters (22) kleiner ist als ein Innendurchmesser der Abschirmhülse (18), sodass der isolierte Leiter (22) in einem Innenbereich der Abschirmhülse (18) in radialer Richtung bewegbar ist.

3. Abschirmungsanordnung (10) gemäß einem der vorhergehenden Ansprüche, wobei die Kabelabschirmung (20) außerhalb des Abschirmgehäuses (12) und außerhalb der Abschirmhülse (18) in einem an die Abschirmhülse (18) angrenzenden Bereich relativ zum isolierten Leiter (22) radial bewegbar ist, sodass die Kabelabschirmung (20) in diesem Bereich und die Abschirmhülse (18) relativ zueinander mechanisch entkoppelt sind.

4. Abschirmungsanordnung (10) gemäß Anspruch 3, wobei die radiale Bewegbarkeit dadurch erreicht wird, dass die Kabelabschirmung (20) in diesem Bereich in ihrer Form veränderbar ist und in diesem Bereich in radialer Richtung aufgeweitet ist.

5. Abschirmungsanordnung (10) gemäß einem der vorhergehenden Ansprüche, wobei die Abschirmungsanordnung (10) im gehäuseseitigen Hülsenbereich (32) und/oder im kabelseitigen Hülsenbereich (34) ein in Umfangsrichtung außen um die Abschirmhülse (18) umlaufendes Befestigungsband (28, 42, 44) aufweist;
wobei das Befestigungsband (28, 42, 44) ausgestaltet ist, einen Anpressdruck auf die jeweiligen Außenflächen der Kontaktlaschen (16) oder einen Anpressdruck auf die Kabelabschirmung (20) in Richtung der Mantelflächen (36, 38) der Abschirmhülse (18) zu erzeugen, sodass die Kontaktlaschen (16) oder die Kabelabschirmung (20) an den jeweiligen Mantelflächen (36, 38) der Abschirmhülse (18) befestigt sind.

6. Abschirmungsanordnung (10) gemäß Anspruch 5, wobei ein Umfang des Befestigungsbandes (28, 42, 44) einstellbar ist, um einen Anpressdruck der Kontaktlaschen (16) und/oder der Kabelabschirmung (20) an die Mantelflächen (36, 38) der Abschirmhülse (18) zu verändern.

7. Abschirmungsanordnung (10) gemäß Anspruch 5 oder 6, wobei das Befestigungsband (28, 42, 44) ein Metall aufweist.

8. Abschirmungsanordnung (10) gemäß Anspruch 5 bis 7, wobei das Befestigungsband (28, 42, 44) einen Kunststoff aufweist und ausgestaltet ist, die Kabelabschirmung (20) mit der Mantelfläche (38) des kabelseitigen Hülsenbereiches (34) konturnah zu umschließen.

9. Abschirmungsanordnung (10) gemäß Anspruch 8, wobei das Befestigungsband (28, 42, 44) eine Schrumpfhülse ist.

10. Abschirmungsanordnung (10) gemäß einem der vorhergehenden Ansprüche, wobei die Abschirmhülse (18) an den jeweiligen längsseitigen Enden der Hülsenbereiche (32, 34) in Umfangsrichtung umlaufende und radial nach außen gerichtete Aufwölbungen (26) aufweist.

11. Abschirmungsanordnung (10) gemäß der Ansprüchen 5 bis 10, wobei die Kontaktlaschen (16) in Ihrer Erstreckung vom Abschirmgehäuse (12) hin zur Mantelfläche (36) stufenförmig verlaufen, sodass ein Teilbereich der Kontaktlaschen (16) im Bereich der Aufwölbungen (26) von einer Zentrumsachse der Abschirmhülse (18) weiter beabstandet ist als ein Teilbereich der Kontaktlaschen (16) zwischen den Aufwölbungen (26) des gehäuseseitigen Hülsenbereiches (32).

12. Abschirmungsanordnung (10) gemäß der Ansprüche 10 oder 11, wobei eine Breite des Bandes (28, 42, 44) in Längsrichtung der Abschirmhülse (18) kleiner ist als ein Abstand zwischen den beiden Aufwölbungen (26) der jeweiligen Hülsenbereiche (32, 34).

13. Abschirmungsanordnung (10) gemäß einem der vorhergehenden Ansprüche, wobei der gehäuseseitige Hülsenbereich (32) und/oder der kabelseitige Hülsenbereich (34) an den Mantelflächen Eintiefungen und/oder Aufwölbungen aufweist.

14. Abschirmungsanordnung (10) gemäß Anspruch 13, wobei ein Profil der Mantelflächen (36, 38) wellenförmig ausgestaltet ist.

15. Steckverbinder für ein Kraftfahrzeug, aufweisend eine Abschirmungsanordnung (10) gemäß Anspruch 1 bis 14.

## Claims

1. Shield arrangement (10) for high-current applications, having
a connection cable (40) comprising an insulated conductor (22) and a cable shield (20) which surrounds the insulated conductor (22);
a shielding housing (12) comprising a bushing (14); wherein the shield arrangement (10) further has a hollow-cylindrical electrically conductive shielding sleeve (18);
wherein the insulated conductor (22) is routed through the shielding sleeve (18);
wherein the shielding sleeve (18) has, at a longitudinal-side end, a housing-side sleeve region (32) and, at another longitudinal-side end, a cable-side sleeve region (34);
wherein the housing-side sleeve region (32) of the shielding sleeve (18) is arranged in the region of the bushing (14) of the shielding housing (12), and the shielding housing (12) comes into contact with a casing surface (36) of the housing-side sleeve region (32); wherein the cable shield (22) bears against a casing surface (38) of the cable-side sleeve region (34), wherein the cable shield (20) is electrically connected to the shielding housing (12) by means of the shielding sleeve (18),
**characterized in that**
the shielding housing (12) forms, in the region of the bushing (14), contact tabs (16) to the outside, which contact tabs extend substantially parallel to the casing surface (36) of the housing-side sleeve region (32) and bear against the casing surface (36) of the housing-side sleeve region (32).

2. Shield arrangement (10) according to Claim 1, wherein a diameter of the insulated conductor (22) is smaller than an inside diameter of the shielding sleeve (18), so that the insulated conductor (22) can be moved in the radial direction in an inner region of the shielding sleeve (18).

3. Shield arrangement (10) according to either of the preceding claims, wherein the cable shield (20), outside the shielding housing (12) and outside the shielding sleeve (18), can be radially moved relative to the insulated conductor (22) in a region adjoining the shielding sleeve (18), so that the cable shield (20) in this region and the shielding sleeve (18) are mechanically decoupled relative to one another.

4. Shield arrangement (10) according to Claim 3, wherein the radial mobility is achieved in that the shape of the cable shield (20) can be changed in this region and the said cable shield is widened in the radial direction in this region.

5. Shield arrangement (10) according to one of the preceding claims, wherein the shield arrangement (10) has, in the housing-side sleeve region (32) and/or in the cable-side sleeve region (34), a fastening strip (28, 42, 44) which runs in the circumferential direction around the outside of the shielding sleeve (18);
wherein the fastening strip (28, 42, 44) is designed to generate a contact pressure on the respective outer surfaces of the contact tabs (16) or a contact pressure on the cable shield (20) in the direction of the casing surfaces (36, 38) of the shielding sleeve (18), so that the contact tabs (16) or the cable shield (20) are/is fastened to the respective casing surfaces (36, 38) of the shielding sleeve (18).

6. Shield arrangement (10) according to Claim 5, wherein a perimeter of the fastening strip (28, 42, 44) is adjustable, in order to change a contact pressure of the contact tabs (16) and/or of the cable shield (20) against the casing surfaces (36, 38) of the shielding sleeve (18).

7. Shield arrangement (10) according to Claim 5 or 6, wherein the fastening strip (28, 42, 44) comprises a metal.

8. Shield arrangement (10) according to Claims 5 to 7, wherein the fastening strip (28, 42, 44) comprises a plastic and is designed to enclose the cable shield (20) with the casing surface (38) of the cable-side sleeve region (34) close to the contour.

9. Shield arrangement (10) according to Claim 8, wherein the fastening strip (28, 42, 44) is a shrink-fit sleeve.

10. Shield arrangement (10) according to one of the preceding claims, wherein the shielding sleeve (18) has circumferential and radially outwardly directed bulges (26) at the respective longitudinal-side ends of the sleeve regions (32, 34).

11. Shield arrangement (10) according to Claims 5 to 10, wherein the contact tabs (16) run in a stepped manner in their extent from the shielding housing (12) towards the casing surface (36), so that a subregion of the contact tabs (16) in the region of the bulges (26) is at a further distance from a centre axis of the shielding sleeve (18) than a subregion of the contact tabs (16) between the bulges (26) of the housing-side sleeve region (32).

12. Shield arrangement (10) according to Claim 10 or 11, wherein a width of the strip (28, 42, 44) in the longitudinal direction of the shielding sleeve (18) is smaller than a distance between the two bulges (26) of the respective sleeve regions (32, 34).

13. Shield arrangement (10) according to one of the preceding claims, wherein the housing-side sleeve region (32) and/or the cable-side sleeve region (34) have/has recesses in and/or bulges on the casing surfaces.

14. Shield arrangement (10) according to Claim 13, wherein a profile of the casing surfaces (36, 38) is of corrugated design.

15. Plug connector for a motor vehicle, having a shield arrangement (10) according to Claims 1 to 14.

## Revendications

1. Système de blindage (10) pour des applications à courants forts, comportant un câble de connexion (40) ayant un conducteur isolé (22) et un blindage de câble (20) entourant le conducteur isolé (22) ;
un boîtier de blindage (12) comportant un passage (14) ;
dans lequel le système de blindage (10) comporte en outre une douille de blindage (18) électriquement conductrice et de forme cylindrique creuse ;
dans lequel le conducteur isolé (22) est guidé à travers la douille de blindage (18) ;
dans lequel la douille de blindage (18) présente à une extrémité longitudinale une zone de douille côté boîtier (32) et à une autre extrémité longitudinale une zone de douille côté câble (34) ;
dans lequel la zone de douille côté boîtier (32) de la douille de blindage (18) est disposée dans la zone du passage (14) du boîtier de blindage (12) et le boîtier de blindage (12) est mis en contact avec une surface extérieure (36) de la zone de douille côté boîtier (32) ;
dans lequel le blindage de câble (22) repose sur une surface extérieure (38) de la zone de douille côté câble (34),
dans lequel le blindage de câble (20) est relié électriquement au boîtier de blindage (12) par l'intermédiaire de la douille de blindage (18), **caractérisé en ce que** le boîtier de blindage (12) forme vers l'extérieur, dans la zone du passage (14), des pattes de contact (16) qui s'étendent sensiblement parallèlement à la surface extérieure (36) de la zone de douille côté boîtier (32) et reposent sur la surface extérieure (36) de la zone de douille côté boîtier (32).

2. Système de blindage (10) selon la revendication 1, dans lequel un diamètre du conducteur isolé (22) est inférieur à un diamètre intérieur de la douille de blindage (18), de manière à ce que le conducteur isolé (22) soit mobile en direction radiale dans une zone intérieure de la douille de blindage (18).

3. Système de blindage (10) selon l'une quelconque des revendications précédentes, dans lequel le blindage de câble (20), à l'extérieur du boîtier de blindage (12) et à l'extérieur de la douille de blindage (18), est mobile radialement dans une zone adjacente à la douille de blindage (18) par rapport au conducteur isolé (22), de manière à ce que le blindage de câble (20) dans cette zone et la douille de blindage (18) soient découplés mécaniquement l'un par rapport à l'autre.

4. Système de blindage (10) selon la revendication 3, dans lequel la mobilité radiale est obtenue en faisant en sorte que la forme du blindage de câble (20) puisse être modifiée dans cette zone et s'évase en direction radiale dans cette zone.

5. Système de blindage (10) selon l'une quelconque des revendications précédentes, dans lequel le système de blindage (10) présente, dans la zone de douille côté boîtier (32) et/ou dans la zone de douille côté câble (34), une bande de fixation (28, 42, 44) entourant la douille de blindage (18) à l'extérieur dans la direction circonférentielle ;
dans lequel la bande de fixation (28, 42, 44) est configurée de manière à produire une pression d'appui sur les surfaces extérieures respectives des pattes de contact (16) ou une pression d'appui sur le blindage de câble (20) dans la direction des surfaces extérieures (36, 38) de la douille de blindage (18) de manière à ce que les pattes de contact (16) ou le blindage de câble (20) soient fixés aux surfaces extérieures (36, 38) respectives de la douille de blindage (18).

6. Système de blindage (10) selon la revendication 5, dans lequel une circonférence de la bande de fixation (28, 42, 44) est réglable afin de modifier une pression d'appui des pattes de contact (16) et/ou du blindage de câble (20) sur les surfaces extérieures (36, 38) de la douille de blindage (18).

7. Système de blindage (10) selon la revendication 5 ou 6, dans lequel la bande de fixation (28, 42, 44) comporte un métal.

8. Système de blindage (10) selon les revendications 5 à 7, dans lequel la bande de fixation (28, 42, 44) comporte une matière plastique et est configurée pour entourer étroitement le blindage de câble (20) avec la surface extérieure (38) de la zone de douille côté câble (34).

9. Système de blindage (10) selon la revendication 8, dans lequel la bande de fixation (28, 42, 44) est une douille thermorétractable.

10. Système de blindage (10) selon l'une quelconque des revendications précédentes, dans lequel la douille de blindage (18) présente, aux extrémités longitudinales respectives des zones de douilles (32, 34), des bombements (26) s'étendant dans la direction circonférentielle et orientés radialement vers l'extérieur.

11. Système de blindage (10) selon les revendications 5 à 10, dans lequel les pattes de contact (16) présentent une extension échelonnée depuis le boîtier de blindage (12) jusqu'à la surface de contact (36), de manière à ce qu'une zone partielle des pattes de contact (16), dans la zone des bombements (26), soit davantage espacée d'un axe central de la douille de blindage (18) qu'une zone partielle des pattes de contact (16) entre les bombements (26) de la zone de douille côté boîtier (32).

12. Système de blindage (10) selon les revendications 10 ou 11, dans lequel une largeur de la bande (28, 42, 44), dans la direction longitudinale de la douille de blindage (18), est inférieure à une distance entre les deux bombements (26) des zones de douilles (32, 34) respectives.

13. Système de blindage (10) selon l'une quelconque des revendications précédentes, dans lequel la zone de douille côté boîtier (32) et/ou la zone de douille côté câble (34) présente des renfoncements et/ou des bombements sur les surfaces extérieures.

14. Système de blindage (10) selon la revendication 13, dans lequel un profil des surfaces extérieures (36, 38) est configuré de manière ondulée.

15. Connecteur destiné à un véhicule automobile, comportant un système de blindage (10) selon les revendications 1 à 14.
